# EUROPEAN PATENT SPECIFICATION

(11) **EP 3 946 931 B1**
(45) Date of publication and mention of the grant of the patent: **07.06.2023**
(21) Application number: 20720124.5
(22) Date of filing: 24.03.2020
(51) Int. Cl.: B32B 15/08, B32B 15/20, B32B 27/28, B32B 27/30, B32B 27/32, B32B 27/34, C23C 20/00, C25D 5/16, C25D 5/56

(54) **MULTILAYER SHEETS, METHODS OF MANUFACTURE, AND ARTICLES FORMED THEREFROM**
MEHRSCHICHTIGE FOLIEN, VERFAHREN ZUR HERSTELLUNG UND DARAUS HERGESTELLTE GEGENSTÄNDE
FEUILLES À COUCHES MULTIPLES, PROCÉDÉS DE FABRICATION ET ARTICLES FORMÉS À PARTIR DE CEUX-CI

(30) Priority: 28.03.2019 EP 19165987
(43) Date of publication of application: 09.02.2022
(73) Proprietor: SHPP Global Technologies B.V., 4612 PX Bergen op Zoom (NL)
(72) Inventor: SONG, Shijie, Shanghai, 201319 (CN); ZHOU, Yuan, Shanghai, 201319 (CN); CHEN, Zhe, Shanghai, 201319 (CN)
(74) Representative: Dehns
(86) International application number: PCT/IB2020/052777
(87) International publication number: WO 2020/194196

(56) References cited:
- WO-A1-2016/092472
- WO-A1-2018/026601
- US-A1- 2013 168 133

## Description

### BACKGROUND

This disclosure relates to multilayer sheets, articles formed therefrom, and their methods of manufacture, and in particular multilayer sheets having electrically conductive patterns, articles formed therefrom, and their methods of manufacture.

Thermoplastics have been used in various electronic components as a substrate material for circuit paths. For example, mobile antennas are usually placed on a single thermoplastic carrier sheet. Nowadays, there is an increasing demand for electronic components to perform multiple functions. Meanwhile, the space that electronic components can be installed has become more limited. Thus, there is a need for electronic components having various service functions with reduced size.

WO 2016/092472 discloses a polymeric sheet including a base layer having opposing sides and a first and second cap layers contacting the opposing sides of the base layer, wherein the first cap layer comprises a first laser-direct additive, and the second cap layer comprises a second LDS additive. WO 2018/026601 discloses a laminate including a polymer film having a first layer containing a thermoplastic polymer and a laser direct structuring additive; a substrate; and an adhesive layer disposed between the polymer film and the substrate. US 2013/168133 discloses a process for producing a circuit carrier, including providing a molded part containing a thermoplastic composition including a thermoplastic resin and a laser direct structuring additive, and irradiating areas of the part on which conductive tracks are to be formed with laser radiation, and subsequently metalizing the irradiated areas.

### SUMMARY

A process of manufacturing a multilayer sheet having electrically conductive patterns is disclosed. The process comprises feeding a first polymer layer and a second polymer composition to a calendering stack, the first polymer layer having an outer surface and an inner surface with an inner electrically conductive pattern disposed thereon, the first polymer layer comprising a first polymer composition which contains a first polymer having a first glass transition temperature, and the second polymer composition comprising a second polymer and a laser direct structure additive, the second polymer having a second glass transition temperature that is 50 to 100 °C lower than the first glass transition temperature, wherein glass transition temperature is determined by differential scanning calorimetry as per ASTM D3418-15 with a 20°C/min heating rate; pressing the first polymer layer and the second polymer composition together to laminate a second polymer layer which comprises the second polymer composition to the first polymer layer, the second polymer layer having an inner surface facing the inner electrically conductive pattern of the first polymer layer and an opposing outer surface; forming an activated surface pattern by activating a portion of the laser direct structure additive on the outer surface of the second polymer layer with a laser machine; and applying a conductive metal on the activated surface pattern to create a second electrically conductive pattern on the outer surface of the second polymer layer; and wherein the first polymer layer is in direct physical contact with the second polymer layer.

A multilayer sheet is also disclosed. The multilayer sheet comprises: a first polymer layer having an inner surface and an opposing outer surface, the first polymer layer comprising a first polymer composition which contains a first laser direct structure additive and a first polymer having a first glass transition temperature; a second polymer layer having an inner surface and an opposing outer surface, the second polymer layer comprising a second polymer composition, which contains a second laser direct structure additive and a second polymer having a second glass transition temperature; a first electrically conductive pattern disposed on the inner surface of the first polymer layer, between the first polymer layer and the inner surface of the second polymer layer; and a second electrically conductive pattern disposed on the outer surface of the second polymer layer, wherein the first polymer layer is in direct physical contact with the second polymer layer; and wherein the second glass transition temperature is 50 to 100°C lower than the first glass transition temperature as determined by differential scanning calorimetry as per ASTM D3418-15 with a 20°C/min heating rate.

### BRIEF DESCRIPTION OF THE DRAWINGS

A description of the figures, which are meant to be exemplary and not limiting, is provided in which:
FIG. 1 is an exploded view of a multilayer sheet according to an embodiment of the disclosure;
FIG. 2 is an exploded view of a multilayer sheet having three layers;
FIGS. 3A, 3B, 3C, and 3D illustrate a process of making a multilayer sheet according to an embodiment of the disclosure;
FIG. 4 is a scanning electron microscope (SEM) image of a cross-section of the multilayer sheet of Example 1; and
FIG. 5 is an optical microscope (OM) image of a cross-section of the multilayer sheet of Example 1.

### DETAILED DESCRIPTION

Multilayer sheets having electrically conductive patterns are provided. Compared with single layer sheets, the multilayer sheets can integrate multiple circuit paths into one component with each layer carrying the same or different conductive patterns, e.g., preferably different conductive patterns on different layers. With the reduced size and integrated functions, multilayer sheets as disclosed herein can offer more flexible design for various electronic devices. In addition, with the careful selection of the carrier material for each layer, the multilayer sheets as disclosed herein, can be readily manufactured, for example, via a continuous process, which is often desired in a commercial setting.

The multilayer sheets according to the disclosure comprise a first polymer layer having an inner surface and an opposing outer surface, the first polymer layer comprising a first polymer composition, which contains a first polymer and a first laser direct structure (LDS) additive; a second polymer layer having an inner surface and an opposing outer surface, the second polymer layer comprising a second polymer composition, which contains a second polymer and a second laser direct structure additive; a first electrically conductive pattern disposed on the inner surface of the first polymer layer and facing the inner surface of the second polymer layer; and a second electrically conductive pattern disposed on the outer surface of the second polymer layer. As used herein, "disposed" or "disposed on" includes embedded or partially embedded. Optionally, the multilayer sheets further comprise a third polymer layer disposed on the outer surface of the first polymer layer and a third electrically conductive pattern disposed on the outer surface of the first polymer layer and facing the third polymer layer. The third polymer layer comprises a third polymer composition, which contains a third polymer and optionally a third laser direct structure additive. The multiplayer sheets can include additional layers if desired. For example, alternatively or in addition, the multilayer sheets can comprise an additional polymer layer disposed on the outer surface of the second or third polymer layer, wherein the additional polymer layer comprises an additional polymer composition which contains an additional polymer.

To manufacture multilayer sheets having structural integrity, the second and the third polymers each independently has a glass transition temperature (Tg) that is 50 to 100 °C lower or 60 to 90 °C lower than the glass transition temperature of the first polymer as determined by differential scanning calorimetry (DSC) as per ASTM D3418-15 with a 20°C/min heating rate. The second and the third polymer layers can comprise the same or different materials. If present, the additional polymer has a glass transition temperature that is 50 to 100 °C lower or 60 to 90 °C lower than the glass transition temperatures of the second and the third polymers determined by differential scanning calorimetry (DSC) as per ASTM D3418-15 with a 20°C/min heating rate. Without wishing to be bound by theory, it is believed that when the Tg difference between the first and second/third polymers is within the described ranges, the second and third polymer layers can be thermally laminated to the opposite sides of the first polymer layer during a thermal lamination process without compromising the material and the structural integrity of the first polymer layer. Likewise, when the Tg difference between the second/third and the additional polymers is within the described ranges, the additional polymer layer can be thermally laminated to the second polymer layer without compromising the material and the structural integrity of the second/third polymer layer.

The first polymer comprises at least one of a polyetherimide, a polyolefin, a polyetheretherketone, a liquid crystal polymer, or a polyphthalamide. The first polymer can be present in the first polymer layer in an amount of 80 to 99 wt%, 85 to 95 wt%, or 90 to 95 wt% based on the total weight of the first polymer layer.

The second, third, or additional polymer layer can comprise a second, third, or additional polymer composition respectively. (collectively, "polymer compositions") The second, third, or additional polymer composition comprises a second, third, or additional polymer, each of which independently can be at least one of a polycarbonate or a polyester. Optionally the second, third, and additional polymer compositions each independently further contains an impact modifier. When used, the weight ratio of the polycarbonate relative to the impact modifier is 50 : 1 to 2 : 1 or 10 : 1 to 3 : 1. The second, third, and additional polymer compositions can comprise 80 to 99 wt%, 85 to 95 wt%, or 90 to 95 wt% of the second, third, or additional polymer respectively when these compositions do not contain impact modifiers. When impact modifiers are present, the second, third, or additional polymer composition comprises 60 to 95 wt% or 70 to 90 wt% of the second, third, or additional polymer based on the total weight of the second, third, or additional polymer composition.

Poly(etherimide)s include polyetherimide homopolymers and copolymers, for example poly(etherimide sulfone)s and poly(etherimide-siloxane)s. Such polyetherimides are described, for example, in US 9,006,319, in WO 2009/10537, and in US 8937,127.

Polyetherimides comprise more than 1, for example 2 to 1000, or 5 to 500, or 10 to 100 structural units of formula (1) 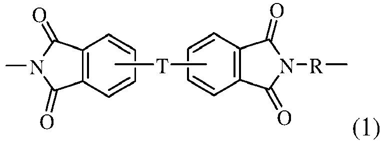 wherein each R is independently the same or different, and is a substituted or unsubstituted divalent organic group, such as a substituted or unsubstituted C₆₋₂₀ aromatic hydrocarbon group, a substituted or unsubstituted straight or branched chain C₄₋₂₀ alkylene group, a substituted or unsubstituted C₃₋₈ cycloalkylene group, in particular a halogenated derivative of any of the foregoing. Preferably, R is divalent group of one or more of the following formulas (2) 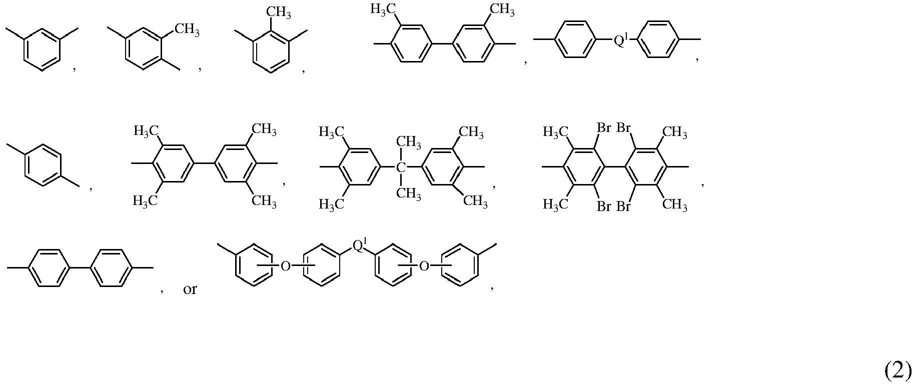 wherein Q¹ is -O-, -S-, -C(O)-, -SO₂-, -SO-, -P(R^{a})(=O)- wherein R^{a} is a C₁₋₈ alkyl or C₆₋₁₂ aryl, -C_{y}H_{2y}- wherein y is an integer from 1 to 5 or a halogenated derivative thereof (which includes perfluoroalkylene groups), or -(C₆H₁₀)_{z}- wherein z is an integer from 1 to 4. Specific examples of R include m-phenylene, p-phenylene, or a diarylene sulfone, in particular bis(4,4'-phenylene)sulfone, bis(3,4'-phenylene)sulfone, bis(3,3'-phenylene)sulfone, or a combination comprising at least one of the foregoing. At least 10 mole percent or at least 50 mole percent of the R groups can contain sulfone groups. Alternatively, no R groups contain sulfone groups.

Further in formula (1), T is -O- or a group of the formula -O-Z-O- wherein the divalent bonds of the -O- or the -O-Z-O- group are in the 3,3', 3,4', 4,3', or the 4,4' positions, and Z is an aromatic C₆₋₂₄ monocyclic or polycyclic moiety optionally substituted with 1 to 6 C₁₋₈ alkyl groups, 1 to 8 halogen atoms, or a combination comprising at least one of the foregoing, provided that the valence of Z is not exceeded. Exemplary groups Z include groups of formula (3) 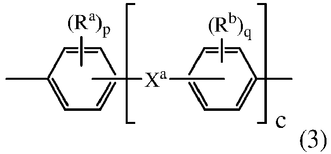 wherein R^{a} and R^{b} are each independently the same or different, and are a halogen atom or a monovalent C₁₋₆ alkyl group, for example; p and q are each independently integers of 0 to 4; c is 0 to 4; and X^{a} is a bridging group connecting the hydroxy-substituted aromatic groups, where the bridging group and the hydroxy substituent of each C₆ arylene group are disposed ortho, meta, or para (specifically para) to each other on the C₆ arylene group. The bridging group X^{a} can be a single bond, -O-, -S-, -S(O)-, -S(O)₂-, -C(O)-, or a C₁₋₁₈ organic bridging group. The C₁₋₁₈ organic bridging group can be cyclic or acyclic, aromatic or non-aromatic, and can further comprise heteroatoms such as halogens, oxygen, nitrogen, sulfur, silicon, or phosphorous. The C₁₋₁₈ organic group can be disposed such that the C₆ arylene groups connected thereto are each connected to a common alkylidene carbon or to different carbons of the C₁₋₁₈ organic bridging group. A specific example of a group Z is a divalent group of formula (3a) 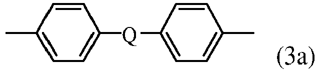 wherein Q is -O-, -S-, -C(O)-, -SO₂-, -SO-, -P(R^{a})(=O)- wherein R^{a} is a C₁₋₈ alkyl or C₆₋₁₂ aryl, or -C_{y}H_{2y}- wherein y is an integer from 1 to 5 or a halogenated derivative thereof (including a perfluoroalkylene group), and optionally Q in formula (3a) is 2,2-isopropylidene.

Preferably, in formula (1), R is m-phenylene, p-phenylene, or a combination comprising at least one of the foregoing, and T is -O-Z-O- wherein Z is a divalent group of formula (3a) and Q is 2,2-isopropylidene. Such materials are available under the trade name ULTEM^{™} from SABIC. The polyetherimide can also be a copolymer comprising additional structural polyetherimide units of formula (1) wherein at least 50 mole percent (mol%) of the R groups are bis(4,4'-phenylene)sulfone, bis(3,4'-phenylene)sulfone, bis(3,3'-phenylene)sulfone, or a combination comprising at least one of the foregoing and the remaining R groups are p-phenylene, m-phenylene or a combination comprising at least one of the foregoing; and Z is 2,2-(4-phenylene)isopropylidene, i.e., a bisphenol A moiety, an example of which is commercially available under the trade name EXTEM from SABIC.

The polyolefins can be a polymer of an alpha-olefin such as polyethylene, polypropylene, and polybutylene. The polyolefin may also be a copolymer of two or more olefins. Preferably, the polyolefin is polyethylene or polypropylene.

Polyetheretherketones comprise repeating units of formula (4) 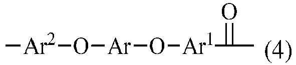 wherein each occurrence of Ar, Ar¹ and Ar² is independently a substituted or unsubstituted, monocyclic or polycyclic aromatic group having 6 to 30 carbons. Examples of Ar, Ar¹ and Ar² groups include, but are not limited to, phenyl, tolyl, naphthyl, and biphenyl. Ar, Ar¹, and Ar² can be the same as or different from each other. Additionally, two of Ar, Arl, and Ar² can be the same as each other and the third can be different. Preferably Ar, Arl, and Ar² are phenyl groups, for example unsubstituted phenyl groups.

Polyphthalamides are aromatic polyamides, which can be produced by condensing an acid such as terephthalic acid, isophthalic acid, or a combination thereof, with an amine. Polyphthalamides comprise repeating units having formula (5) 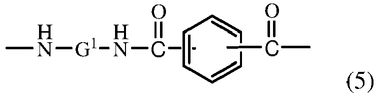 wherein each G¹ is independently a branched or unbranched C₄₋₈ alkyl such as 1,6-hexyl group. Polyphthalamides can be a homopolymer or a block copolymer or a random copolymer comprising the units of formula (5) and units of formula (6) 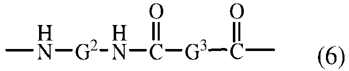 wherein each G² and G³ are independently a branched or unbranched C₄₋₁₂ alkyl group.

"Polycarbonate" as used herein means a homopolymer or copolymer having repeating structural carbonate units of the formula (7) 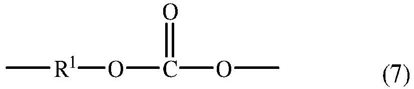 wherein at least 60 percent of the total number of R¹ groups are aromatic, or each R¹ contains at least one C₆₋₃₀ aromatic group. Polycarbonates and their methods of manufacture are known in the art and have been described, for example, in WO 2013/175448 A1, US 2014/0295363, and WO 2014/072923. Polycarbonates are generally manufactured from bisphenol compounds such as 2,2-bis(4-hydroxyphenyl) propane ("bisphenol-A" or "BPA"), 3,3-bis(4-hydroxyphenyl) phthalimidine, 1,1-bis(4-hydroxy-3-methylphenyl)cyclohexane, or 1,1-bis(4-hydroxyphenyl)-3,3,5-trimethylcyclohexane (isophorone), or a combination comprising at least one of the foregoing bisphenol compounds can also be used. The polycarbonate can be a homopolymer derived from BPA; a copolymer derived from BPA and another bisphenol or dihydroxy aromatic compound such as resorcinol; or a copolymer derived from BPA and optionally another bisphenol or dihydroxy aromatic compound, and further comprising non-carbonate units, for example aromatic ester units such as resorcinol terephthalate or isophthalate, aromatic-aliphatic ester units based on C₆₋₂₀ aliphatic diacids, polysiloxane units such as polydimethylsiloxane units, or a combination comprising at least one of the foregoing. The polycarbonates can have a glass transition temperature of 120°C to 180°C, determined by differential scanning calorimetry (DSC) as per ASTM D3418-15 with a 20°C/min heating rate. A specific example of the polycarbonate is a bisphenol A polycarbonate homopolymer.

Polyesters include those derived from an aliphatic, cycloaliphatic, or aromatic diol, or mixtures thereof, containing from 2 to about 10 carbon atoms and an aliphatic, cycloaliphatic, or aromatic dicarboxylic acid, and have repeating units of the following general formula: 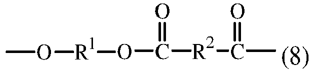 wherein n is an integer of from 2 to 6, and R¹ and R² are each independently a divalent C₁-C₂₀ aliphatic radical, a C₂-C₁₂ cycloaliphatic alkyl radical, or a C₆-C₂₄ aromatic radical.

The polyesters can be formed from terephthalic acid and a combination of ethylene glycol and cyclohexadimethanol; preferably formed from terephthalic acid and a combination of ethylene glycol, diethylene glycol and cyclohexadimethanol. Examples of polyesters include at least one of poly(ethylene terephthalate), polycyclohexylenedimethylene terephthalate glycol, poly(1,4-cyclohexylenedimethylene 1,4-cyclohexanedicarboxylate), polyethyelene naphthalate, poly-cyclohexylenedimethylene-terephthalate-glycol, polycyclohexylenedimethylene terephthalate, or polyethylene terephthalate with diethylene glycol. Preferably the polyester comprises poly(ethylene terephthalate) ("PET"), e.g., unmodified PET, polybutylene terephthalate (PBT), and the like.

Impact modifiers include but not limited to, for example, an acrylonitrile-butadiene-styrene polymer (ABS), an acrylonitrile-styrene-butyl acrylate (ASA) polymer, a methyl methacrylate-acrylonitrile-butadiene-styrene (MABS) polymer, a methyl methacrylate-butadiene-styrene (MBS) polymer, and an acrylonitrile-ethylene-propylene-diene-styrene (AES) polymer. In a still further aspect, the impact modifier is an acrylonitrile-butadiene-styrene polymer ("ABS polymer"). In a still further aspect, the impact modifier is a bulk polymerized ABS polymer ("BABS polymer" or "Bulk ABS polymer").

The laser direct structuring (LDS) additives in the first, second, third, and any additional polymer layers can be the same or different. A laser direct structuring additive is selected such that, after activating with a laser, a conductive path can be formed by a subsequent metallization or plating process. Specifically, when the laser direct structuring additive is exposed to a laser, elemental metal is released or activated; and in areas not exposed to the laser beam, no metal atoms are released or activated. The laser thus draws a pattern on the polymer layers and leaves behind a roughened surface containing released or activated metal particles. These metal particles act as nuclei for the crystal growth during a subsequent metallization or plating process.

Examples of the laser direct structuring additives include metal oxides such as oxides of a heavy metal such as chromium, copper, or a combination thereof, or a copper salt such as copper hydroxide phosphate, copper phosphate, copper sulfate, cuprous thiocyanate, or a combination including at least one of the foregoing LDS additives. These laser direct structuring additives can also have spinel type crystal structures. Preferably, the laser direct structuring additives comprise copper chromium oxide, more preferably copper chromium oxide having spinel type crystal structures. Commercially available laser direct structuring additives include PK3095 black pigment (CAS # 68186-91-4), commercially available from Ferro Corp., USA and Black 1G pigment black 28 (CAS # 68186-91-4) commercially available from The Shepherd Color company.

The laser direct structuring additive can be present in the polymer layers or polymer compositions in an amount of 1 wt% to 15 wt%, 3 wt% to 10 wt%, or 5 wt% to 10 wt% based on the total weight of the polymer layers or polymer compositions. The amount of the laser direct structuring additive in different polymer layers can be the same or different.

In addition to the thermoplastic polymers and the LDS additive, the polymer layers or polymer compositions can include various additives ordinarily incorporated into polymer compositions of this type, with the proviso that the additive(s) are selected to not adversely affect the desired properties of the polymers in the polymer layers. Such additives can be mixed at a suitable time during the mixing of the components for forming the polymer layers. Exemplary additives include fillers, reinforcing agents, antioxidants, heat stabilizers, light stabilizers, ultraviolet (UV) light stabilizers, plasticizers, lubricants, mold release agents, antistatic agents, colorants (such as carbon black and organic dyes), surface effect additives, radiation stabilizers (e.g., infrared absorbing), flame retardants, and anti-drip agents. A combination of additives can be used, for example, a combination of a heat stabilizer, mold release agent, and ultraviolet light stabilizer. The total amount of additives (other than any impact modifier, filler, or reinforcing agents) can be 0.001 weight percent (wt%) to 5 wt%, based on the total weight of the compositions of the polymer layers or polymer compositions.

The conductive patterns formed from the laser structuring additives can be in direct physical contact with adjacent polymer layers, and there are no adhesives used. For example, the first electrically conductive pattern can be in direct physical contact with both the inner surface of the first polymer layer and the inner surface of the second polymer layer. The second electrically conductive pattern can be in direct physical contact with the outer surface of the second polymer layer. Likewise, the third electrically conductive pattern can be in direct physical contact with the outer surface of the first polymer layer and an inner surface of the third polymer layer. Additional polymer layers and conductive patterns can be present if needed. In an aspect, both of the adjacent polymer layers contain laser structuring additives. There are no adhesives or substrates or other layers disposed between the adjacent polymer layers, and the adjacent polymer layers are in direct physical contact with each other. For example, each of the first and second polymer layers contains a laser structuring additive, and the first and second polymer layers are in direct physical contact with each other.

The electrically conductive patterns can vary in terms of path, shape, and functions. As used herein, electrically conductive patterns include circuit paths. The electrically conductive patterns can function as microwave/millimeter wave circuits, ground layers, interconnection structures, patch antenna layers, and the like.

The conductive patterns at different layers may be electrically isolated or electrically connected depending on the end use of the multilayer sheets. When the conductive patterns at different layers are electrically connected, the patterns can be connected via an additional electrical conductive pattern generated on a side surface of the laminated layers via LDS and plating processes. Alternatively or in addition, the conductive patterns at different layers can be connected through an electrically conductive pathway penetrating through the layers. For example, connection can be formed by first drilling a hole through the laminated layers, and then forming an electrically conductive pathway through the hole (e.g., using LDS and plating processes to form conductive lines on the inner wall of the hole to connect the conductive patterns on different layers).

The electrically conductive patterns include conductive metals. As used herein, a conductive metal refers to a metal or a metal alloy having a conductivity of greater than 1 × 10⁶ Siemens per meter (S/m), greater than 5 × 10⁶ S/m, or greater than 1 × 10⁷ S/m at 20°C. Examples of the conductive metals include copper, gold, nickel, silver, zinc, palladium, chromium, tin, or alloys thereof. Combinations of the metals can be used. Copper is specifically mentioned. The conductive metals in the conductive patterns can be the same or different from the metals in the LDS additives.

The overall thickness of the multilayer sheets can be up to and even exceeding several millimeters. More specifically, the multilayer sheets can have a thickness (e.g., gauge) of 200 micrometers to 1 millimeter, and specifically 300 micrometers to 600 micrometers. Multilayer sheets having other thicknesses can also be manufactured depending on the end use of the sheets. Each polymer layers can have a thickness of 100 micrometers to 500 millimeters, specifically 150 to 300 micrometers. When the thickness of a polymer layer is less than 100 micrometers, laser may penetrate the polymer layer during a LDS process. The thickness of the electrically conductive pattern disposed on each polymer layer can be 2 to 15 micrometers or 5 to 10 micrometers.

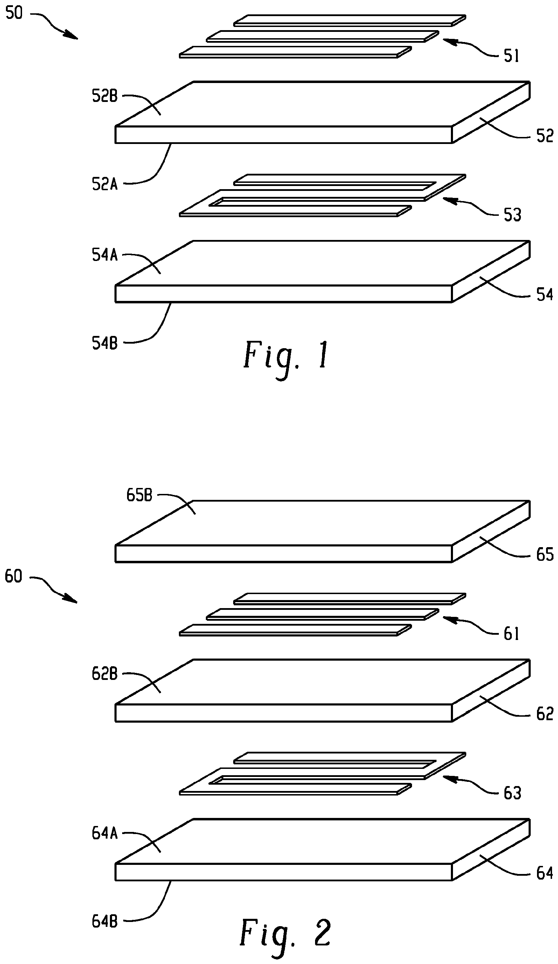

FIG. 1 is an exploded view of a multilayer sheet according to an embodiment of the disclosure. As shown in FIG. 1, a multilayer sheet 50 has a first polymer layer 54, a second polymer layer 52, a first conductive pattern 53 disposed on an inner surface 54A of the first polymer layer 54 and facing an inner surface 52A of the second polymer layer 52; and a second conductive pattern 51 disposed on an outer surface 52B of the second polymer layer 52. Another conductive pattern (not shown) can be optionally formed on an outer surface 54B of the first polymer layer 54.

FIG. 2 is an exploded view of a multilayer sheet having at least three polymer layers 65, 62, and 64. The multilayer sheet also has a first conductive pattern 61 disposed on surface 62B and facing layer 65 and a second conductive pattern 63 disposed on surface 62A and facing layer 64. Optionally, additional conductive patterns can be formed on surfaces 65B or 64B.

Advantageously, the multilayer sheets as disclosed herein can be manufactured by thermal lamination. The process comprises feeding a first polymer layer and a second polymer composition to a calendering stack, the first polymer layer having an outer surface and an inner surface with an inner electrically conductive pattern disposed thereon, the first polymer layer comprising a first polymer composition which contains a first polymer having a first glass transition temperature, and the second polymer layer comprising a second polymer composition which contains a second polymer and a laser direct structure additive, the second polymer having a second glass transition temperature that is 50 to 100 °C lower than the first glass transition temperature, wherein glass transition temperature is determined by differential scanning calorimetry as per ASTM D3418-15 with a 20°C/min heating rate; pressing the first polymer layer and the second polymer composition together to laminate a second polymer layer which contains the second polymer composition to the first polymer layer, the second polymer layer having an inner surface facing the inner electrically conductive pattern of the first polymer layer and an opposing outer surface; forming an activated surface pattern by activating a portion of the laser direct structure additive on the outer surface of the second polymer layer with a laser machine; and applying a conductive metal on the activated surface pattern to create a second electrically conductive pattern on the outer surface of the second polymer layer. Additional polymer layers can be laminated as described herein.

The first polymer layer fed to the calendering stack, which has an inner surface with an inner conductive pattern disposed thereon and an opposing outer surface, can be manufactured by injection molding, extrusion, rotational molding, blow molding, thermoforming, and the like, from a first polymer composition containing a first polymer and a laser direct structure additive. The laser direct structure additive on the inner surface of the first polymer layer is then activated with a laser machine to form an activated surface; and a conductive metal is applied to (e.g., plated on) the activated surface to form the inner conductive pattern on the first polymer layer.

The second polymer composition fed to the calendering stack can be in the form of a layer or a molten composition formed by extrusion. Preferably, a molten second polymer composition is fed to the calendering stack immediately after extrusion together with the first polymer layer comprising the electrically conductive pattern. The molten second polymer composition can also be cooled first after passing through a die forming a second polymer layer before it is fed to the calendering stack together with the first polymer layer. The second polymer composition can have a surface temperature between a second polymer Tg and a second polymer Tg - 50 °C, between a second polymer Tg and a second polymer Tg - 20 °C, or between a second polymer Tg and a second polymer Tg - 10 °C when the second polymer composition is fed to the calendering stack together with the first polymer layer, wherein the a second polymer Tg is the glass transition temperature of the second polymer determined by differential scanning calorimetry (DSC) as per ASTM D3418-15 with a 20°C/min heating rate.

In a continuous process, an extruder (e.g., a single screw extruder) can supply a polymer melt (e.g. a second polymer melt) into a feed block of an extruder apparatus. A die forms a molten polymer composition, which is then fed together with the first polymer layer to a calendering stack.

The calendering stack can comprise two to four counter-rotating cylindrical rolls. Suitable materials for the rolls include plastic, metal (e.g., chrome, stainless steel, aluminum, and the like), rubber (e.g., EPDM), ceramic materials, and the like. Preferably the rolls are made from metal (e.g., steel) or rubber coated metal. It is generally noted that the size of the rolls, material of the rolls, number of rolls, the film wrap around the rolls, and the like, can vary with the system employed. Each roll can be heated or cooled, as is appropriate.

The first polymer layer and second polymer composition can be successively squeezed between the calendering rolls to form a laminate. The temperature of the rolls can be set based on the Tg of the second polymer. The rolls that contact the first polymer layer can have a temperature of a second polymer Tg - 50°C to a second polymer Tg + 10°C, a second polymer Tg - 20°C to a second polymer Tg + 10°C, or a second polymer Tg - 10°C to a second polymer Tg + 10°C. The rolls that contact the second polymer composition can have a temperature of a second polymer Tg - 50°C to a second polymer Tg, a second polymer Tg - 20°C to a second polymer Tg, or a second polymer Tg - 10°C to a second polymer Tg. As a specific example, the first polymer layer comprises a polyetherimide having a Tg of 190 - 225°C, and the second polymer layer or molten composition comprises a polycarbonate (having a Tg of 120 - 180°C), the temperature of the rolls that contact the first polymer layer can be 130 - 140°C, and the temperature of the rolls that contact the second polymer layer/molten composition can be 120 - 130°C.

After passing through the inter-roll clearance ("nip"), the laminate can be cooled (e.g., to a temperature less than the T_{g} of the molten material), and can then be passed through pull rolls. Nip pressures can be 1 bar (100,000 Pascal) to 20 bars (2,000,000 Pascals). The line speed can be adjusted based on the extruder type, output, thickness of the sheet. In generally a line speed of 1 meter per minute (m/min) to 30 m/min is preferable. A mask can optionally be applied to the cooled laminate to protect the laminate from damage or contamination.

Next, a laser direct structuring (LDS) process is carried out to form an electrically conductive path on the outer surface of the second polymer layer. Initially a laser beam is applied to the outer surface of the second polymer layer to activate the laser direct additive according to a predetermined pattern to form an activated or etched surface. The process can also be referred to as laser etching. Laser etching can be carried out at a broad window of the laser parameters, e.g., at 1 watt (W) to 10 W power with a frequency from 30 kilohertz (kHz) to 110 kHz and a speed of 1 meter per second (m/s) to 5 m/s. Preferably, laser etching is carried out at 1 W to 10 W power with a frequency from 40 kHz to 100 kHz and a speed of 2 m/s to 4 m/s.

A rough surface can form after laser etching. As used herein, "rough surface" refers to a surface that has been laser etched and has a surface roughness that is greater than its surface roughness before laser etching.

Conductive metals as described herein can be applied on the activated surface to form electrically conductive patterns. For example, a plating process can be used. Optionally, an electroless copper plating bath can be used during the plating process. The plating temperature can be 50 to 80°C or 60 to 70°C.

The multilayer sheet comprising the conductive pattern (preferably comprising at least two conductive patterns) can be put onto a winder to supply the product in a roll form, cut on-line into a sheeted material, or optionally the roll form can be sheeted off-line and cut into lengths suitable for handling.

The multilayer sheets can include additional polymer layers. For example, the process can further comprise laminating a third polymer layer to the outer surface of the first polymer layer. The third polymer layer comprises a third polymer composition, which includes a third polymer and optionally a laser direct structure additive, wherein the third polymer has a third glass transition temperature that is 50 to 100 °C lower than the glass transition temperature of the first polymer. The second and third polymer compositions can be the same or different.

The second and third polymer layers can be simultaneously laminated to the first polymer layer. In this instance, same or different conductive patterns can be formed on the opposing sides of the first polymer layer first to provide a patterned first polymer layer, then the patterned first polymer layer, a second polymer composition, and a third polymer composition disposed at the opposing patterned surfaces of the first polymer layer are fed to the calendering stack to laminate a second polymer layer which comprises the second polymer composition, a third polymer layer which comprises the third polymer composition to the opposite sides of the first polymer layer. After the lamination, additional conductive patterns can be formed on the outer surfaces of the second or third polymer layer.

Alternatively, the second and third polymer layers can be sequentially laminated to the first polymer layer. In this instance, a second polymer layer can be first laminated to a first polymer layer according to a process as described herein. Then before the third polymer layer is laminated, an outer electrically conductive pattern, if not formed already before the first polymer layer is laminated to the second polymer layer, can be formed on the outer surface of the first polymer layer, e.g., via a LDS and a plating process as described herein. The third polymer layer can be laminated to the first polymer layer by feeding the third polymer composition and a laminate of the first and second polymer layers to a calendering stack. After the lamination, additional conductive patterns can be formed on outer surfaces of the second or third polymer layer.

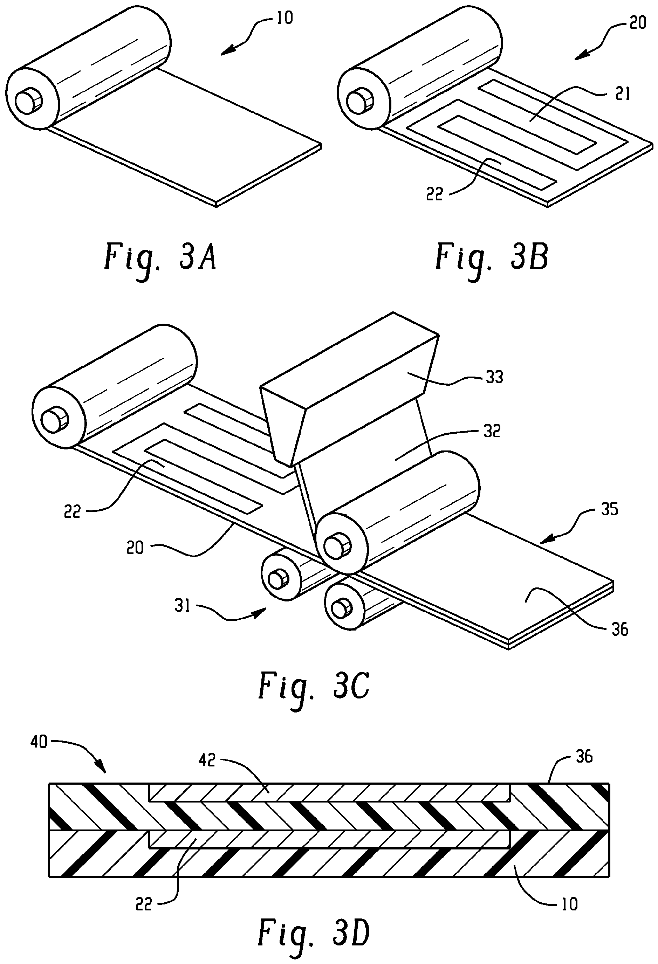

The process can be a continuous process or a discontinuous process. A specific example of a process of manufacturing a multilayer sheet as disclosed herein is illustrated in FIGS 3A-3D. As shown in these figures, a roll of a first polymer layer 10 is first provided. An electrically conductive pattern 22 is formed on an inner surface 21 of the first polymer layer 10 via a LDS process to provide a patterned first polymer layer 20. Next, a molten second polymer composition 32, formed from a die 33, is fed to a calendering stack 31 together with the patterned first polymer layer 20, with the conductive pattern 22 facing the molten second polymer composition. After passing through the calendering stack 31, a laminate 35 is formed. An electrically conductive pattern 42 is then formed on an outer surface 36 of the laminate 35 via a LDS process to form a multilayer sheet 40.

The multilayer sheets are useful in the production of components for various articles. An example of the components is antennas. Illustrative articles include computer devices, household appliances, decoration devices, electromagnetic interference devices, printed circuits, Wi-Fi devices, Bluetooth devices, GPS devices, cellular antenna devices, smart phone devices, automotive devices, military devices, aerospace devices, medical devices, such as hearing aids, sensor devices, security devices, shielding devices, RF antenna devices, or RFID devices.

### EXAMPLES

### Examples 1-3

The materials used in the examples are described in Table 1.

**Table 1.**

| Abbreviation | Chemical Description | Source |
|---|---|---|
| LDS additive | Copper chromite oxide, loading level 8 wt% | Shepherd Chemical |
| PEI/LDS | A blend of polyetherimide and a LDS additive | SABIC |
| PC/LDS | A blend of a bisphenol A polycarbonate and a LDS additive | SABIC |
| PC/ABS/LDS | A blend of a bisphenol A polycarbonate, an acrylonitrile-butadiene-styrene, and a LDS additive | SABIC |

Various multilayer sheets as shown in Table 2 were constructed under the conditions indicated therein. LDS was activated via a laser beam, and then the laser activated area was plated through an electroless-plating process. The plating temperature was 60°C to 70°C, and the plating solvent contained a copper salt. The plating process lasted for 1.5 hours. The thickness of the plated metal was 5 to 10 micrometers (µm).

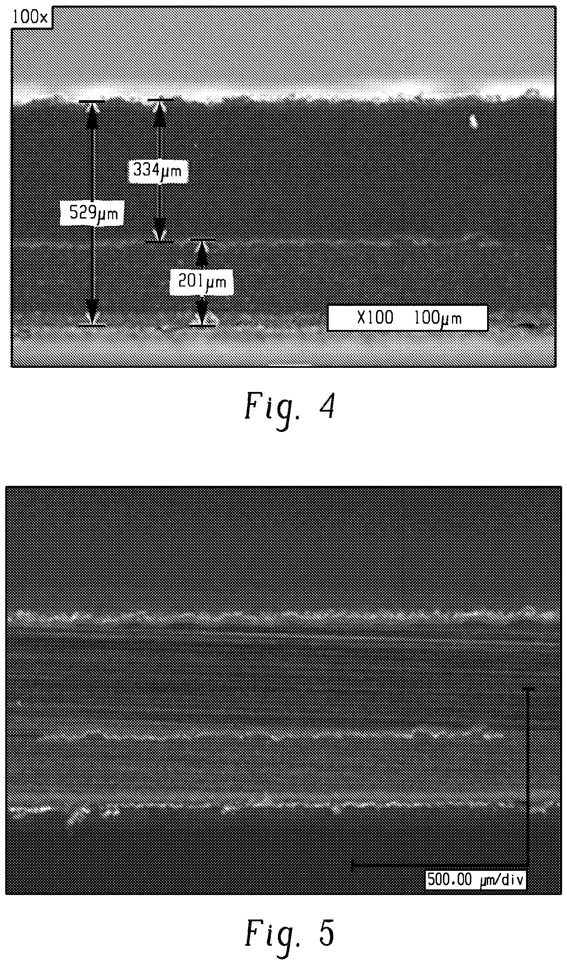

A scanning electron microscope (SEM) image and an optical microscope (OM) image of a cross-section of the multilayer sheet of Example 1 are shown in FIG. 4 and FIG. 5 respectively.

**Table 2.**

| | | Sample 1 | Sample 2 | Sample 3 |
|---|---|---|---|---|
| | Total layers | Two | Two | Three |
| | Total gauge | 530 µm | 530 µm | 630 µm |
| First layer | Base material | PEI/LDS | PEI/LDS | PEI/LDS |
| | Thickness | 330 µm | 330 µm | 330 µm |
| | Extrusion Temp. (°C) | 330 | 330 | 330 |
| | Calender rolls Temp. (°C) | 130 | 130 | 130 |
| | Line speed (m•min⁻¹) | 1.55 | 1.55 | 1.55 |
| | Metal pattern | copper | copper | copper |
| Second layer | Base material | PC/LDS | PC/ABS/LDS | PC/LDS |
| | Thickness | 200 µm | 200 µm | 150 µm |
| | Extrusion Temp. (°C) | 260 | 240 | 260 |
| | Calender rolls Temp. (°C) | 120 | 110 | 120 |
| | Nip pressure (bar) | 10 | 10 | 10 |
| | Line speed (m•min⁻¹) | 2.58 | 2.42 | 5.66 |
| | Metal pattern | copper | copper | copper |
| Third layer | Base material | None | None | PC/LDS (on the other side of the PEI laver) |
| | Thickness | None | None | 150 µm |
| | Extrusion Temp. (°C) | None | None | 260 |
| | Calender rolls Temp. (°C) | None | None | 120 |
| | Nip pressure (bar) | None | None | 10 |
| | Line speed (m•min⁻¹) | None | None | 5.66 |
| | Metal pattern | None | None | copper |

The examples demonstrate that multilayer sheets having several electrically conductive patterns can be readily manufactured via extrusion and thermal lamination processes. The conductive patterns in each layer can have customized design by adjusting the laser activation pattern. The multilayer sheets also have structural integrity as shown in FIGS. 4 and 5.

## Claims

1. A process of manufacturing a multilayer sheet having electrically conductive patterns, the process comprising:
feeding a first polymer layer and a second polymer composition to a calendering stack,
the first polymer layer having an outer surface and an inner surface with an inner electrically conductive pattern disposed thereon, the first polymer layer comprising a first polymer composition which contains a first polymer having a first glass transition temperature, and
the second polymer composition comprising a second polymer and a laser direct structure additive, the second polymer having a second glass transition temperature that is 50 to 100 °C lower than the first glass transition temperature, wherein glass transition temperature is determined by differential scanning calorimetry as per ASTM D3418-15 with a 20°C/min heating rate;
pressing the first polymer layer and the second polymer composition together to laminate a second polymer layer which contains the second polymer composition to the first polymer layer, the second polymer layer having an inner surface facing the inner electrically conductive pattern of the first polymer layer and an opposing outer surface;
forming an activated surface pattern by activating a portion of the laser direct structure additive on the outer surface of the second polymer layer with a laser machine; and
applying a conductive metal on the activated surface pattern to create a second electrically conductive pattern on the outer surface of the second polymer layer;
wherein the first polymer layer is in direct physical contact with the second polymer layer.

2. The process of claim 1, wherein the second polymer composition is at a molten state when fed to the calendering stack together with the first polymer layer.

3. The process of any one of claims 1 to 2, further comprising forming the inner electrically conductive pattern on the inner surface of the first polymer layer by:
forming a first activated surface pattern by activating a portion of a first laser direct structure additive on the inner surface of the first polymer layer with a laser machine; and
applying a first conductive metal on the first activated surface pattern on the first polymer layer to create the inner conductive pattern on the inner surface of the first polymer layer.

4. The process of any one of claims 1 to 3, wherein the first polymer layer further has an outer electrically conductive pattern disposed on the outer surface of the first polymer layer.

5. The process of any one of claims 1 to 4, further comprising laminating a third polymer layer to the outer surface of the first polymer layer, wherein the third polymer layer comprises a third polymer composition which contains a third polymer having a third glass transition temperature that is 50 to 100°C lower than the first glass transition temperature.

6. The process of any one of claims 1 to 5, further comprising laminating an additional polymer layer to the outer surface of the second polymer layer, wherein the additional polymer layer comprises an additional polymer composition, which contains an additional polymer having an additional glass transition temperature that is 50 to 100°C lower than the second glass transition temperature.

7. The process of any one of claims 1 to 6, wherein the process is a continuous process.

8. The process of any one of claims 1 to 7, wherein the first polymer comprises at least one of a polyetherimide, a polyolefin, a polyetheretherketone, a liquid crystal polymer, or a polyphthalamide.

9. The process of any one of claims 6 to 8, wherein the second polymer, the third polymer, and the additional polymer each, independently, comprises at least one of a polycarbonate or a polyester, and preferably wherein the second polymer, the third polymer, and the additional polymer, each, independently, comprise a polycarbonate having a glass transition temperature of 120°C to 180°C, determined by differential scanning calorimetry as per ASTM D3418-15 with a 20°C/min heating rate, and optionally wherein the second, the third, and the additional polymer compositions each independently further comprises an impact modifier comprising at least one of an acrylonitrile-butadiene-styrene, an acrylonitrile-styrene-butyl acrylate, a methyl methacrylate-acrylonitrile-butadiene-styrene, a methyl methacrylate-butadiene-styrene, or an acrylonitrile-ethylene-propylene-diene-styrene.

10. The process of any one of claims 1 to 9, wherein the laser direct structuring additive comprises at least one of an oxide of chromium, an oxide of copper, an oxide of chromium and copper, copper hydroxide phosphate, copper phosphate, copper sulfate, or cuprous thiocyanate.

11. A multilayer sheet comprising:
a first polymer layer having an inner surface and an opposing outer surface, the first polymer layer comprising a first polymer composition, which contains a first laser direct structure additive and a first polymer having a first glass transition temperature;
a second polymer layer having an inner surface and an opposing outer surface, the second polymer layer comprising a second polymer composition, which contains a second laser direct structure additive and a second polymer having a second glass transition temperature;
a first electrically conductive pattern disposed on the inner surface of the first polymer layer, between the first polymer layer and the inner surface of the second polymer layer; and
a second electrically conductive pattern disposed on the outer surface of the second polymer layer,
wherein the first polymer layer is in direct physical contact with the second polymer layer; and
the second glass transition temperature is 50 to 100°C lower than the first glass transition temperature as determined by differential scanning calorimetry as per ASTM D3418-15 with a 20°C/min heating rate.

12. The multilayer sheet of claim 11, wherein the first polymer layer further has an outer electrically conductive pattern disposed on the outer surface of the first polymer layer and the multilayer sheet further comprises a third polymer layer disposed on the outer surface of the first polymer layer.

13. The multilayer sheet of claim 12, wherein the first polymer comprises at least one of a polyetherimide or a polyolefin, and the second polymer and the third polymer each independently comprises a polycarbonate, and the first and second laser direct structure additives each independently comprises at least one of an oxide of chromium, an oxide of copper, an oxide of chromium and copper, copper hydroxide phosphate, copper phosphate, copper sulfate, or cuprous thiocyanate.

14. An article comprising the multilayer sheet of any one of claims 11 to 13.

## Patentansprüche

1. Verfahren zum Herstellen einer mehrschichtigen Folie, die elektrisch leitfähige Muster aufweist, das Verfahren umfassend:
Zuführen einer ersten Polymerschicht und einer zweiten Polymerzusammensetzung zu einem Kalandrierungsstapel,
wobei die erste Polymerschicht eine äußere Oberfläche und eine innere Oberfläche mit einem darauf angeordneten inneren elektrisch leitfähigen Muster aufweist, wobei die erste Polymerschicht eine erste Polymerzusammensetzung umfasst, die ein erstes Polymer enthält, das eine erste Glasübergangstemperatur aufweist, und
wobei die zweite Polymerzusammensetzung ein zweites Polymer und ein Laser-Direkt-Strukturadditiv umfasst, wobei das zweite Polymer eine zweite Glasübergangstemperatur aufweist, die 50 bis 100 °C niedriger als die erste Glasübergangstemperatur ist, wobei die Glasübergangstemperatur durch dynamische Differenzkalorimetrie gemäß ASTM D3418-15 mit einer Aufheizrate von 20 °C/min bestimmt wird;
Zusammenpressen der ersten Polymerschicht und der zweiten Polymerzusammensetzung, um eine zweite Polymerschicht, die die zweite Polymerzusammensetzung enthält, auf die erste Polymerschicht zu laminieren, wobei die zweite Polymerschicht eine innere Oberfläche aufweist, die dem inneren elektrisch leitfähigen Muster der ersten Polymerschicht zugewandt ist, und eine gegenüberliegende äußere Oberfläche;
Ausbilden eines aktivierten Oberflächenmusters durch Aktivieren eines Abschnitts des Laser-Direkt-Strukturadditivs auf der äußeren Oberfläche der zweiten Polymerschicht mit einer Lasermaschine; und
Aufbringen eines leitfähigen Metalls auf das aktivierte Oberflächenmuster, um ein zweites elektrisch leitfähiges Muster auf der äußeren Oberfläche der zweiten Polymerschicht zu erzeugen;
wobei die erste Polymerschicht in direktem physischem Kontakt mit der zweiten Polymerschicht steht.

2. Verfahren nach Anspruch 1, wobei sich die zweite Polymerzusammensetzung in einem geschmolzenen Zustand befindet, wenn sie dem Kalandrierungsstapel zusammen mit der ersten Polymerschicht zugeführt wird.

3. Verfahren nach einem der Ansprüche 1 bis 2, ferner umfassend das Ausbilden des inneren elektrisch leitfähigen Musters auf der inneren Oberfläche der ersten Polymerschicht durch:
Ausbilden eines ersten aktivierten Oberflächenmusters durch Aktivieren eines Abschnitts eines ersten Laser-Direkt-Strukturadditivs auf der inneren Oberfläche der ersten Polymerschicht mit einer Lasermaschine; und
Aufbringen eines ersten leitfähigen Metalls auf das erste aktivierte Oberflächenmuster auf der ersten Polymerschicht, um das innere leitfähige Muster auf der inneren Oberfläche der ersten Polymerschicht zu erzeugen.

4. Verfahren nach einem der Ansprüche 1 bis 3, wobei die erste Polymerschicht ferner ein äußeres elektrisch leitfähiges Muster aufweist, das auf der äußeren Oberfläche der ersten Polymerschicht angeordnet ist.

5. Verfahren nach einem der Ansprüche 1 bis 4, ferner umfassend das Laminieren einer dritten Polymerschicht auf die äußere Oberfläche der ersten Polymerschicht, wobei die dritte Polymerschicht eine dritte Polymerzusammensetzung umfasst, die ein drittes Polymer enthält, das eine dritte Glasübergangstemperatur aufweist, die 50 bis 100 °C niedriger als die erste Glasübergangstemperatur ist.

6. Verfahren nach einem der Ansprüche 1 bis 5, ferner umfassend das Laminieren einer zusätzlichen Polymerschicht auf die äußere Oberfläche der zweiten Polymerschicht, wobei die zusätzliche Polymerschicht eine zusätzliche Polymerzusammensetzung umfasst, die ein zusätzliches Polymer enthält, das eine zusätzliche Glasübergangstemperatur aufweist, die 50 bis 100°C niedriger als die zweite Glasübergangstemperatur ist.

7. Verfahren nach einem der Ansprüche 1 bis 6, wobei das Verfahren ein kontinuierliches Verfahren ist.

8. Verfahren nach einem der Ansprüche 1 bis 7, wobei das erste Polymer mindestens eines von einem Polyetherimid, einem Polyolefin, einem Polyetheretherketon, einem Flüssigkristallpolymer oder einem Polyphthalamid umfasst.

9. Verfahren nach einem der Ansprüche 6 bis 8, wobei das zweite Polymer, das dritte Polymer und das zusätzliche Polymer jeweils unabhängig mindestens eines von einem Polycarbonat oder einem Polyester umfassen, und vorzugsweise, wobei das zweite Polymer, das dritte Polymer und das zusätzliche Polymer jeweils unabhängig voneinander ein Polycarbonat umfassen, das eine Glasübergangstemperatur von 120°C bis 180 °C aufweist, bestimmt durch dynamische Differentialkalorimetrie gemäß ASTM D3418-15 mit einer Aufheizrate von 20 °C/min, und optional, wobei die zweite, die dritte und die zusätzliche Polymerzusammensetzung jeweils unabhängig ferner einen Aufprallmodifikator umfassen, der mindestens eines von einem Acrylnitril-Butadien-Styrol, einem Acrylnitril-Styrol-Butylacrylat, einem Methylmethacrylat-Acrylnitril-Butadien-Styrol, einem Methylmethacrylat-Butadien-Styrol oder einem Acrylnitril-Ethylen-Propylen-Di-Styrol umfasst.

10. Verfahren nach einem der Ansprüche 1 bis 9, wobei das Laser-Direkt-Strukturierungsadditiv mindestens eines von einem Chromoxid, Kupferoxid, Chrom- und Kupferoxid, Kupferhydroxidphosphat, Kupferphosphat, Kupfersulfat oder Kupferthiocyanat umfasst.

11. Mehrschichtige Folie, umfassend:
eine erste Polymerschicht, die eine innere Oberfläche und eine gegenüberliegende äußere Oberfläche aufweist, wobei die erste Polymerschicht eine erste Polymerzusammensetzung umfasst, die ein erstes Laser-Direkt-Strukturadditiv und ein erstes Polymer enthält, das eine erste Glasübergangstemperatur aufweist;
eine zweite Polymerschicht, die eine innere Oberfläche und eine gegenüberliegende äußere Oberfläche aufweist, wobei die zweite Polymerschicht eine zweite Polymerzusammensetzung umfasst, die ein zweites Laser-Direkt-Strukturadditiv und ein zweites Polymer enthält, das eine zweite Glasübergangstemperatur aufweist;
ein erstes elektrisch leitfähiges Muster, das auf der inneren Oberfläche der ersten Polymerschicht angeordnet ist, zwischen der ersten Polymerschicht und der inneren Oberfläche der zweiten Polymerschicht; und
ein zweites elektrisch leitfähiges Muster, das auf der äußeren Oberfläche der zweiten Polymerschicht angeordnet ist,
wobei die erste Polymerschicht in direktem physischem Kontakt mit der zweiten Polymerschicht steht; und
die zweite Glasübergangstemperatur 50 bis 100 °C niedriger ist als die erste Glasübergangstemperatur, wie durch dynamische Differenzkalorimetrie gemäß ASTM D3418-15 mit einer Aufheizrate von 20 °C/min bestimmt.

12. Mehrschichtige Folie nach Anspruch 11, wobei die erste Polymerschicht ferner ein äußeres elektrisch leitfähiges Muster aufweist, das auf der äußeren Oberfläche der ersten Polymerschicht angeordnet ist, und das mehrschichtige Blatt ferner eine dritte Polymerschicht umfasst, die auf der äußeren Oberfläche der ersten Polymerschicht angeordnet ist.

13. Mehrschichtige Folie nach Anspruch 12, wobei das erste Polymer mindestens eines von einem Polyetherimid oder einem Polyolefin umfasst und das zweite Polymer und das dritte Polymer jeweils unabhängig ein Polycarbonat umfassen, und das erste und das zweite Laser-Direkt-Strukturadditiv jeweils unabhängig voneinander ein Chromoxid, ein Kupferoxid, ein Chrom- und Kupferoxid, Kupferhydroxidphosphat, Kupferphosphat, Kupfersulfat oder Kupferthiocyanat umfassen.

14. Erzeugnis, umfassend die mehrschichtige Folie nach einem der Ansprüche 11 bis 13.

## Revendications

1. Procédé de fabrication d'une feuille multicouche ayant des motifs électriquement conducteurs, le procédé comprenant :
l'alimentation d'une première couche de polymère et d'une deuxième composition de polymère pour une pile de calandrage,
la première couche de polymère ayant une surface externe et une surface interne avec un motif électriquement conducteur interne disposé sur celle-ci, la première couche de polymère comprenant une première composition de polymère qui contient un premier polymère ayant une première température de transition vitreuse, et
la deuxième composition de polymère comprenant un deuxième polymère et un additif de structuration directe par laser, le deuxième polymère ayant une deuxième température de transition vitreuse qui est de 50 à 100 °C inférieure à la première température de transition vitreuse, la température de transition vitreuse étant déterminée par analyse calorimétrique différentielle selon la norme ASTM D3418-15 avec une vitesse de chauffage de 20 °C/min ;
le pressage de la première couche de polymère et de la deuxième composition de polymère ensemble pour stratifier une deuxième couche de polymère qui contient la deuxième composition de polymère sur la première couche de polymère, la deuxième couche de polymère ayant une surface interne faisant face au motif électriquement conducteur interne de la première couche de polymère et une surface externe opposée ;
la formation d'un motif de surface activé en activant une partie de l'additif de structuration directe par laser sur la surface externe de la deuxième couche de polymère avec une machine laser ; et
l'application d'un métal conducteur sur le motif de surface activé pour créer un second motif électriquement conducteur sur la surface externe de la deuxième couche de polymère ;
la première couche de polymère étant en contact physique direct avec la deuxième couche de polymère.

2. Procédé selon la revendication 1, dans lequel la deuxième composition de polymère est à un état fondu lorsqu'elle est introduite dans la pile de calandrage conjointement avec la première couche de polymère.

3. Procédé selon l'une quelconque des revendications 1 à 2, comprenant en outre la formation du motif électriquement conducteur interne sur la surface interne de la première couche de polymère par :
la formation d'un premier motif de surface activé en activant une partie d'un premier additif de structuration directe par laser sur la surface interne de la première couche de polymère avec une machine laser ; et
l'application d'un premier métal conducteur sur le premier motif de surface activé sur la première couche de polymère pour créer le motif conducteur interne sur la surface interne de la première couche de polymère.

4. Procédé selon l'une quelconque des revendications 1 à 3, dans lequel la première couche de polymère a en outre un motif électriquement conducteur externe disposé sur la surface externe de la première couche de polymère.

5. Procédé selon l'une quelconque des revendications 1 à 4, comprenant en outre la stratification d'une troisième couche de polymère sur la surface externe de la première couche de polymère, la troisième couche de polymère comprenant une troisième composition de polymère qui contient un troisième polymère ayant une troisième température de transition vitreuse qui est de 50 à 100 °C inférieure à la première température de transition vitreuse.

6. Procédé selon l'une quelconque des revendications 1 à 5, comprenant en outre la stratification d'une couche de polymère supplémentaire sur la surface externe de la deuxième couche de polymère, la couche de polymère supplémentaire comprenant une composition de polymère supplémentaire, qui contient un polymère supplémentaire ayant une température de transition vitreuse supplémentaire qui est de 50 à 100 °C inférieure à la deuxième température de transition vitreuse.

7. Procédé selon l'une quelconque des revendications 1 à 6, dans lequel le procédé est un procédé continu.

8. Procédé selon l'une quelconque des revendications 1 à 7, dans lequel le premier polymère comprend au moins l'un parmi un polyétherimide, une polyoléfine, un polyétheréthercétone, un polymère à cristaux liquides ou un polyphtalamide.

9. Procédé selon l'une quelconque des revendications 6 à 8, dans lequel le deuxième polymère, le troisième polymère, et le polymère supplémentaire, chacun, indépendamment, comprend au moins l'un parmi un polycarbonate ou un polyester, et de préférence le deuxième polymère, le troisième polymère, et le polymère supplémentaire, chacun, indépendamment, comprenant un polycarbonate ayant une température de transition vitreuse de 120 °C à 180 °C, déterminée par analyse calorimétrique différentielle selon la norme ASTM D3418-15 avec une vitesse de chauffage de 20 °C/min, et éventuellement la deuxième, la troisième et la composition polymère supplémentaire, chacune, indépendamment comprenant en outre un modificateur d'impact comprenant au moins l'un parmi un acrylonitrile-butadiène-styrène, un acrylonitrile-styrène-acrylate de butyle, un méthacrylate de méthyle-acrylonitrile-butadiène-styrène, un méthacrylate de méthyle-butadiène-styrène, ou un acrylonitrile-éthylène-propylène-diène-styrène.

10. Procédé selon l'une quelconque des revendications 1 à 9, dans lequel l'additif de structuration directe par laser comprend au moins l'un parmi un oxyde de chrome, un oxyde de cuivre, un oxyde de chrome et de cuivre, un phosphate d'hydroxyde de cuivre, un phosphate de cuivre, un sulfate de cuivre, ou un thiocyanate cuivreux.

11. Feuille multicouche comprenant :
une première couche de polymère ayant une surface interne et une surface externe opposée, la première couche de polymère comprenant une première composition de polymère, qui contient un premier additif de structuration directe par laser et un premier polymère ayant une première température de transition vitreuse ;
une deuxième couche de polymère ayant une surface interne et une surface externe opposée, la deuxième couche de polymère comprenant une deuxième composition de polymère, qui contient un second additif de structuration directe par laser et un deuxième polymère ayant une deuxième température de transition vitreuse ;
un premier motif électriquement conducteur disposé sur la surface interne de la première couche de polymère, entre la première couche de polymère et la surface interne de la deuxième couche de polymère ; et
un second motif électriquement conducteur disposé sur la surface externe de la deuxième couche de polymère,
la première couche de polymère étant en contact physique direct avec la deuxième couche de polymère ; et
la deuxième température de transition vitreuse étant de 50 à 100 °C inférieure à la première température de transition vitreuse telle que déterminée par analyse calorimétrique différentielle selon la norme ASTM D3418-15 avec une vitesse de chauffage de 20 °C/min.

12. Feuille multicouche selon la revendication 11, dans laquelle la première couche de polymère a en outre un motif électriquement conducteur externe disposé sur la surface externe de la première couche de polymère et la feuille multicouche comprend en outre une troisième couche de polymère disposée sur la surface externe de la première couche de polymère.

13. Feuille multicouche selon la revendication 12, dans laquelle le premier polymère comprend au moins l'un parmi un polyétherimide ou une polyoléfine, et le deuxième polymère et le troisième polymère comprennent chacun indépendamment un polycarbonate, et les premier et second additifs de structuration directe par laser comprennent chacun indépendamment au moins l'un parmi un oxyde de chrome, un oxyde de cuivre, un oxyde de chrome et de cuivre, un phosphate d'hydroxyde de cuivre, un phosphate de cuivre, un sulfate de cuivre, ou un thiocyanate cuivreux.

14. Article comprenant la feuille multicouche selon l'une quelconque des revendications 11 à 13.
